# FASCICULE DE BREVET EUROPEEN

(11) **EP 0 763 282 B1**
(45) Date de publication et mention de la délivrance du brevet: **26.09.2007**
(21) Numéro de dépôt: 96910992.5
(22) Date de dépôt: 28.03.1996
(51) Int. Cl.: H03K 19/0185, H03K 19/00

(54) **DISPOSITIF D'INTERFACAGE DE SIGNAUX LOGIQUES DU NIVEAU ECL AU NIVEAU CMOS**
SCHNITTSTELLE ZUM UMSETZEN LOGISCHER ECL-PEGEL IN CMOS-PEGEL
ECL LEVEL/CMOS LEVEL LOGIC SIGNAL INTERFACING DEVICE

(30) Priorité: 29.03.1995 FR 9503713
(43) Date de publication de la demande: 19.03.1997
(73) Titulaire: ATMEL NANTES SA, 44300 Nantes (FR)
(72) Inventeur: GERBER, Rémi, F-44300 Nantes (FR)
(74) Mandataire: Fréchède, Michel
(86) Numéro de dépôt international: PCT/FR1996/000469
(87) Numéro de publication internationale: WO 1996/031006

(56) Documents cités:
- EP-A- 0 436 823
- DE-A- 4 010 145
- US-A- 4 968 905
- US-A- 5 317 214
- US-A- 5 329 182
- US-A- 5 332 935

## Description

L'invention concerne un dispositif d'interfaçage de signaux logiques du niveau ECL au niveau CMOS.

Dans les circuit intégrés actuels, notamment les circuits logiques, il est essentiel de permettre la commutation d'un niveau logique bas à un niveau logique haut ou réciproquement, dans une plage d'amplitude de commutation réduite.

En particulier dans les structures dites ECL *("Emitter coupled Logic"* en langage anglo-saxon, pour logique à émetteur couplé), la commutation entre niveau logique bas et haut est définie entre 3,2 V (niveau bas) et 4,1 V (niveau haut).

Ce type de circuit, de plus en plus répandu, pose toutefois le problème de la compatibilité de ces niveaux logiques avec les niveaux logiques des circuits intégrés CMOS pour lesquels le niveau logique bas est inférieur à 1 V et le niveau logique haut sensiblement égal à 5 V. Le problème de compatibilité posé concerne non seulement les valeurs des tensions d'alimentation de ces circuits, mais également la continuité de la transmission de l'information logique en raison notamment du risque d'ambiguïté, par absence de discrimination des niveaux logiques ECL par rapport aux niveaux logiques CMOS.

Différentes solutions ont été proposées dans un contexte voisin relatif à l'absence de compatibilité entre niveaux logiques BTL, circuits logiques à basse tension, niveau logique bas 1,1 V, niveau logique haut 1,9 V et TTL *(Transistor Transistor Logic)* ou CMOS.
Une solution envisagée dans le contexte précité peut consister à engendrer une tension de seuil commune, intermédiaire entre le niveau logique haut et le niveau logique bas TTL et CMOS, et à effectuer une discrimination de ces niveaux logiques par rapport à cette valeur de seuil.
Cette solution donne satisfaction, mais elle présente toutefois les inconvénients ci-après :
- présence d'une structure rapportée permettant d'engendrer la tension de seuil commune, et, de discriminer les niveaux logiques précités ;
- consommation d'une surface importante dans le cas de l'intégration de cette structure rapportée sous forme de circuit intégré et consommation correspondante de silicium. La transposition d'une telle solution aux circuits logiques ECL n'est donc pas à rechercher, en raison de la persistance des inconvénients précités.

Ces types de dispositifs peuvent être illustrés à partir des documents ci-après :
- Le document EP-A-0 595 318 décrit un dispositif comportant un comparateur différentiel d'entrée, lequel engendre un signal en phase avec le signal d'entrée, un circuit inverseur 21 et un circuit inverseur de mise en forme.
- Le document US-A-5,332,935 décrit une structure comparable, dans laquelle toutefois il est nécessaire d'apporter une tension extérieure.
Ces dispositifs, en raison de cette entrée différentielle ou de référence, et de la connexion de cette dernière, présentent l'inconvénient de la consommation importante de surface, mentionnée précédemment.

La présente invention a pour objet de remédier à ces inconvénients grâce à la mise en oeuvre d'un dispositif d'interfaçage des signaux logiques ECL au niveau CMOS, dans lequel la mise en oeuvre de toute tension de seuil commune et d'une discrimination par rapport à cette tension de seuil est supprimée.

Un autre objet de la présente invention est également la mise en oeuvre d'un dispositif d'interfaçage de signaux logiques ECL au niveau CMOS dans lequel la continuité de la transmission de l'information logique est assurée grâce à la mise en oeuvre de transitions entre valeurs de tension des niveaux logiques bas et haut d'amplitudes progressives et compatibles.

Le dispositif d'interfaçage de signaux logiques du niveau ECL au niveau CMOS, objet de la présente invention, est conforme à la revendication 1.

Un tel dispositif trouve application à la fabrication de circuits intégrés ou de composants pour circuits intégrés.

Il sera mieux compris à la lecture de la description et à l'observation des dessins ci-après'dans lesquels :
- la figure 1 représente un schéma synoptique fonctionnel du dispositif objet de la présente invention
- la figure 2a représente à titre d'exemple non limitatif un schéma d'un mode de réalisation du dispositif objet de l'invention, selon la figure 1, en technologie CMOS ; et
- les figures 2b1 à 2b4 représentent des chronogrammes de signaux obtenus aux points de test de la figure 2a.

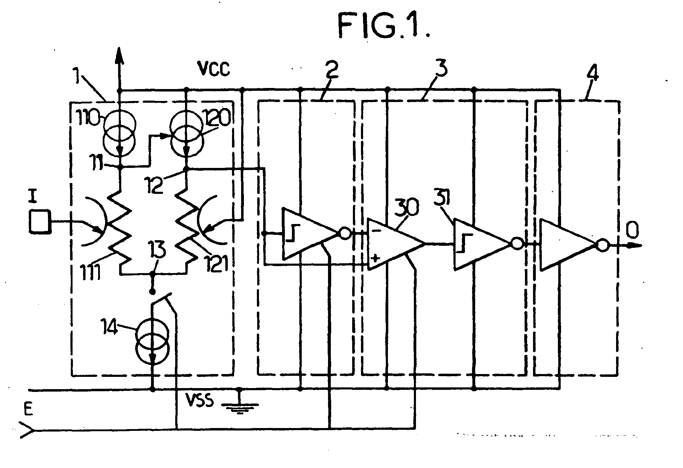

Une description plus détaillée du dispositif d'interfaçage de signaux logiques du niveau ECL au niveau CMOS, objet de la présente invention, sera maintenant donnée en liaison avec la figure 1.

Le dispositif, objet de l'invention, représenté en figure 1, est normalement alimenté par une tension d'alimentation au niveau CMOS, notée VCC, par rapport à une tension de référence VSS.

Il est composé d'une série de modules montés en cascade, ces modules étant constitués successivement par un circuit 1 générateur d'un signal en phase avec le signal d'entrée au niveau ECL, ce signal d'entrée étant noté I. Le signal en phase présente, conformément à une caractéristique particulièrement avantageuse du dispositif objet de la présente invention, une amplitude supérieure à celle du signal d'entrée I et une valeur d'amplitude moyenne supérieure à celle de ce même signal d'entrée au niveau ECL.

Un circuit 2 inverseur à seuil est prévu, lequel reçoit sur une entrée d'inversion le signal en phase délivré par le circuit 1, ce circuit inverseur à seuil 2 présentant un seuil de commutation dont la valeur de seuil est sensiblement égale à la valeur d'amplitude moyenne du signal en phase précitée. Le circuit 2 inverseur à seuil délivre un signal en phase inversé.

Un circuit 3 de mise en forme est prévu ce circuit 3 de mise en forme étant connecté au circuit 2 inverseur à seuil, afin de recevoir le signal en phase inversé délivré par ce dernier. Il délivre un signal.. en phase calibré inversé.

Enfin, un circuit 4 amplificateur inversion de sortie est prévu, ce circuit étant connecté au circuit 3 de mise en forme, ce circuit amplificateur inverseur de sortie recevant le signal en phase calibre inversé délivré par ce dernier et délivrant un signal de sortie, noté O, au niveau CMOS, ce signal étant sensiblement en phase avec le signal d'entrée I.

Ainsi qu'on l'a en outre représenté en figure 1 et de manière particulièrement avantageuse, le circuit 1 générateur d'un signal en phase, le circuit 2 inverseur à seuil et le circuit 3 de mise en forme peuvent comporter un circuit de commande recevant un signal de commande E permettant de réduire la consommation statique d'énergie électrique en mode veille du dispositif d'interfaçage objet de la présente invention. Selon une caractéristique supplémentaire avantageuse, on indique que le circuit de commande précité permet d'appliquer en sortie du circuit amplificateur 4 un signal de sortie au niveau CMOS permettant d'inhiber la consommation statique de tout circuit aval connecté à cette sortie et en particulier des matrices de mémoire CMOS connectées au dispositif selon l'invention tel que représenté en figure 1, pour assurer l'interfaçage entre des signaux d'entrée ECL et des unités de mémoire de type CMOS par exemple.

Le mode opératoire des circuits de commande permettant de réaliser les fonctions de réduction de consommation statique d'énergie électrique précédemment cités sera décrit ultérieurement dans la description.

Ainsi qu'on l'a représenté en outre en figure 1, on indique que le circuit 1 générateur d'un signal en phase avec le signal d'entrée I comprend un circuit comparateur de courant formé par une branche d'entrée, notée 11, et une branche d'amplification, notée 12, les deux branches étant connectées en parallèle entre la tension d'alimentation au niveau CMOS, VCC, et un point commun, noté 13. La branche d'entrée et la branche d'amplification sont formées chacune par un générateur de courant, notés 110 respectivement 120, et une résistance ajustable en tension, 111 respectivement 121. La sortie du générateur de courant 110 de la branche d'entrée 11 est couplée à une entrée de commande du générateur de courant 120 de la branche d'amplification 12. En outre, l'entrée de commande de la résistance ajustable en tension 111 de la branche d'entrée 11 est reliée à une borne d'entrée, laquelle reçoit le signal d'entrée I alors que l'entrée de commande de la résistance ajustable 121 de la branche d'amplification 12 est reliée à la tension d'alimentation au niveau CMOS, VCC.

Enfin, ainsi que représenté sur la figure 1, le circuit 1 générateur du signal en phase avec le signal d'entrée comprend une source de courant atténuée, notée 14, laquelle est connectée en cascade avec la branche d'entrée et la branche d'amplification en parallèle, c'est-à-dire entre le point commun 13 et la tension de référence VSS.

Le circuit 1 générateur du signal en phase avec le signal d'entrée permet de délivrer la tension en phase au niveau du point de connexion entre le générateur de courant 120 et la résistance ajustable en tension 121 de la branche d'amplification 12, ainsi qu'il sera décrit ultérieurement dans la description.

Ainsi qu'on l'a représenté en outre en figure 1, le circuit 3 de mise en forme comprend avantageusement un comparateur de tension à sortie unique, noté 30 lequel reçoit sur ses entrées de comparaison négative respectivement positive, le signal en phase inversé délivré par le circuit 2 inverseur et le signal en phase délivré par le circuit 1 générateur d'un signal en phase avec le signal d'entrée au niveau ECL. Le circuit comparateur de tension à : sortie unique 30 délivre un signal de comparaison du signal en phase et du signal en phase inversé précités constituant un signal en phase calibré. Le circuit 3 de mise en forme comprend également un module 31 inverseur de mise en forme proprement dit, recevant le signal de comparaison délivré par le comparateur 30 de tension à sortie unique, signal de comparaison du signal en phase et du signal en phase inversé, et délivrant le signal en phase calibré inversé

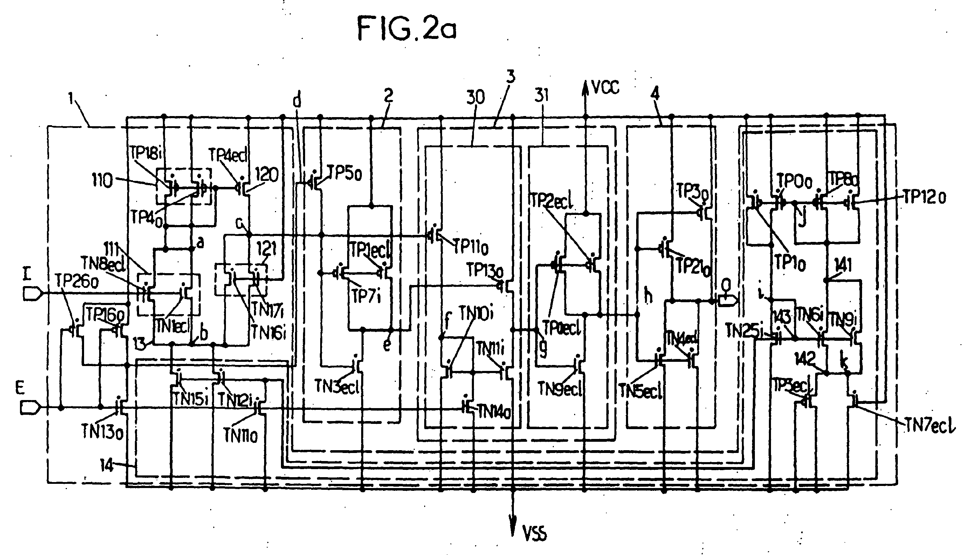

Une description plus détaillée des éléments constitutifs du dispositif objet de la présente invention, dans un mode de réalisation en technologie CMOS, sera maintenant donnée en liaison avec la figure 2a.

Dans le mode de réalisation considéré, on indique que, selon la représentation conventionnelle, l'électrode des transistors MOS à laquelle est affecté un point représente l'électrode de drain de ce transistor MOS.

Ainsi qu'on l'a représenté sur la figure 2a précitée, on indique que le générateur de courant 110 de la branche d'entrée 11 du circuit comparateur de courant constitutif du circuit 1 générateur d'un signal en phase avec le signal d'entrée est formé par deux transistors PMOS connectés en parallèle, portant la référence TP18i, est connecté entre la tension d'alimentation VCC et le point commun 11 constituant en fait un premier point de test a.

De la même manière, on indique que le circuit générateur de courant 120 de la branche d'amplification 12 est constitué par un transistor PMOS portant la référence TP4ecl. L' électrode de grille du transistor PMOS précité 120 est interconnectée et reliée au point 11 constituant le point de test a.

En outre, la résistance ajustable en tension 111 de la branche d'entrée 11 est constituée par deux transistors NMOS en parallèle, portant la référence TN8ecl, TNlecl, ces transistors étant ainsi interconnectés entre le point constituant le point de test a et le point commun 13 constituant un deuxième point de test b. Les électrodes de grille des transistors NMOS, TN8ecl et TN1ecl, sont reliées à une borne d'entrée, laquelle reçoit le signal d'entrée ECL référencé I.

De la même manière, on indique que la résistance ajustable en tension 121 est formée par deux transistors NMOS connectés en parallèle entre l'électrode de source du transistor PMOS 120 constitutif du générateur de courant 120, et le point commun 13 précité constituant le deuxième point de test b. On indique que le point commun formé par les électrodes de drain des deux transistors NMOS portant la référence TN17i et TN16i formant la résistance ajustable en tension 121 constitue un troisième point de test c.

En outre, la source de courant atténuée 14 est formée par un premier et un deuxième transistor NMOS, référencés TN15i et TN12i, connectés en parallèle entre le point commun 13 constituant le point de test b et la tension de référence VSS. Les deux transistors NMOS précités formant une source de courant sont reliés par leur électrode de grille à un module de commande d'atténuation délivrant une tension de commande d'atténuation à l'électrode de grille des transistors NMOS TN15i et TN12i.

Ainsi qu'on l'a représenté sur la même figure 2a, on indique que le module de commande d'atténuation comprend une source de courant formée par un premier et un deuxième transistor PMOS connectés en parallèle entre la tension d'alimentation au niveau CMOS, VCC, et un premier point commun 141. Les transistors PMOS sont référencés TP8o, TP12o. L'électrode de grille du premier et du deuxième transistor PMOS précités est connectée au premier point commun 141, lequel délivre un courant constant, sensiblement.

Le module de commande d'atténuation comprend également une résistance formée par un transistor PMOS et un transistor NMOS, connectés en parallèle entre un deuxième point commun 142 et la tension de référence VSS, les transistors portant la référence TP3ecl, TN7ecl. L'électrode de grille du transistor TN7ecl est reliée à la tension d'alimentation VCC et celle du transistor TP3ecl est reliée à la tension de référence VSS.

En outre, un circuit générateur de tension est formé par un premier et un deuxième transistor NMOS, référencés TN6i, TN9i, connectés en parallèle entre le premier, 141, et le deuxième point commun 142. L'électrode de grille du premier et du deuxième transistor NMOS précités est reliée à un troisième point commun, 143, lequel constitue le point de test i et auquel est interconnectée l'électrode de grille du premier et du deuxième transistor NMOS portant les références TN15i et TN12i formant le générateur de courant constituant la source de courant atténuée 14.

En outre, le circuit générateur de tension comprend, d'une part, un premier et un deuxième transistor PMOS connectés en parallèle, portant la référence TP1o, TP0o, entre la tension d'alimentation au niveau CMOS, VCC, et le quatrième point commun 143. L'électrode de grille des transistors PMOS précités est connectée à l'électrode de grille du premier et du deuxième transistor PMOS TP8o, TP12o, constituant la source de courant, ainsi que, d'autre part, un transistor NMOS, noté TN25i, connecté entre le quatrième point commun 143 constituant le point de test i et la tension de référence VSS, l'électrode de grille du transistor NMOS, TN25i, étant reliée au troisième point commun 143 et délivrant la tension de commande d'atténuation à l'électrode de grille des transistors TN15i, TN12i.

En ce qui concerne le circuit inverseur à seuil 2, on indique que celui-ci peut comprendre, ainsi que représenté en figure 2a, un premier et un deuxième transistor PMOS, référencés TP7i, TPlecl, connectés en parallèle entre la tension d'alimentation CMOS, VCC, et un point commun constituant un point de test e. Les électrodes de grille du premier et du deuxième transistor PMOS précités sont connectées en sortie du circuit 1 générateur d'un signal en phase et reçoivent ce dernier signal.

Un transistor NMOS, portant la référence TN3ecl, est connecté en cascade entre le point commun formant point de test e et la tension de référence VSS, l'électrode de grille de ce transistor étant connectée en sortie du circuit générateur du signal en phase et recevant ce dernier. Le circuit inverseur à seuil 1 délivre ainsi au point commun constituant le point de test e le signal en phase inversé.

En ce qui concerne le circuit de mise en forme 3, un mode de réalisation tel que représenté en figure 2a peut comporter, pour la réalisation du comparateur de tension à sortie unique 30, un étage d'entrée formé par un transistor PMOS, portant la référence TP11o, connecté en cascade avec un transistor NMOS, portant la référence TN10i, l'ensemble de ces deux transistors étant monté entre la tension d'alimentation VCC et la tension de référence VSS. Le point commun entre électrode de source et de drain des transistors précités constitue un point de test f, lequel est relié à l'électrode de grille du transistor NMOS, TN10i. L'électrode de grille du transistor PMOS TP11o constitutif de l'étage d'entrée est reliée au point de test c, c'est-à-dire en sortie du circuit 1 générateur du signal en phase. En outre, l'étage d'entrée précédemment cité est suivi d'un étage de sortie formé par un transistor PMOS, référencé TP13o, et un transistor NMOS, référencé TN11i, connectés en cascade entre la tension d'alimentation VCC et la tension de référence VSS. Le point commun entre électrodes de source et de drain des transistors précités constitue un point de test g, lequel forme la borne de sortie du comparateur de tension à sortie unique.

En ce qui concerne le module inverseur de mise en forme proprement dit 31, celui-ci, ainsi que représenté en figure 2a, peut avantageusement être constitué par un premier et un deuxième transistor PMOS connectés en parallè-le, portant la référence TPOecl TP2ecl, entre la tension d'alimentation au niveau CMOS, VCC, et un point commun constituant un point de test h, ainsi que par un transistor NMOS, portant la référence TN9ecl, connecté entre le point commun formant le point de test h et la tension de référence VSS. Les électrodes de grille des transistors PMOS, TPlecl et TP2ecl, et NMOS, TN9ecl, sont reliées au point de test g, c'est-à-dire en fait en sortie du comparateur de tension à sortie unique 30. Le signal en phase calibré inversé est ainsi délivré au point commun constituant le point de test h.

Enfin, en ce qui concerne le circuit amplificateur inverseur de sortie 4, celui-ci peut être formé par un étage d'entrée constitué par un transistor PMOS, TP210, connecté en cascade avec un transistor NMOS, noté TN5ecl, entre la tension d'alimentation VCC et la tension de référence VSS, et par un étage de sortie formé par un transistor PMOS portant la référence TP3o, monté en cascade avec un transistor NMOS, TN4ecl, entre tension d'alimentation et tension de référence précitées. Le point commun entre électrodes de source et de drain des transistors précités est relié au point commun des transistors de l'étage d'entrée pour former une borne de sortie délivrant le signal de sortie au niveau CMOS en phase avec le signal d'entrée.

En ce qui concerne les circuits de commande permettant de réduire la consommation statique d'énergie électrique en mode veille, on indique que ces circuits de commande sont directement intégrés au niveau de chaque module constitutif du dispositif objet de l'invention tel que représenté en figure 2a.

En particulier, pour le circuit 1 générateur d'un signal en phase, ce circuit de commande comprend deux transistors PMOS, référencés TP26o, TP16o, connectés en parallèle, ces deux transistors parallèles étant en outre connectés en série avec un transistor NMOS, noté TN13o, entre la tension d'alimentation VCC et la tension de référence VSS. Les électrodes de grille de ces transistors sont connectées à une borne d'entrée d'un signal de commande de réduction de la consommation, signal de commande noté E.

En outre, un transistor de commande est également prévu, transistor de type NMOS, noté TN11o, ce transistor étant monté en parallèle entre les électrodes de grille des transistors TN15i, TN12i, constitutifs du générateur de courant de la source de courant atténuée 14 et la tension de référence VSS. L'électrode de grille du transistor TN11o est reliée à la borne recevant le signal de commande E.

En ce qui concerne le circuit de commande de réduction de consommation statique d'énergie électrique au niveau du circuit 2 inverseur à seuil, on indique que celui-ci est constitué par un transistor de type PMOS,portant la référence TP5o, connecté entre la tension d'alimentation au niveau CMOS, VCC, et le point de test c constituant la sortie du circuit 1 générateur d'un signal en phase. L'électrode de grille du transistor PMOS TP5o est reliée au point commun des transistors PMOS TP26o, TP16o, et NMOS TN13o.

En ce qui concerne le circuit de mise en forme, on indique que le circuit de commande de réduction de la consommation statique d'énergie électrique est implanté au niveau du comparateur de tension à sortie unique 30 et constitué par un transistor NMOS, noté TN14o, connecté entre le point commun constituant le point de test f et la tension de référence VSS, l'électrode de grille de ce transistor étant reliée à la borne recevant le signal de commande E.

Le fonctionnement de l'ensemble des éléments représentés en figure 2a est le suivant.

Lorsque par exemple le signal d'entrée ECL, noté I, s'élève de 3,2 V à 4,1 V, la tension de grille des transistors TN8ecl et TNlecl s'élève en conséquence. Ceci provoque la réduction de la résistance existante entre les électrodes de drain et de source de ces deux transistors. Le courant engendré par les transistors TP18i et TP4o constitutifs du générateur de courant 110 étant sensiblement constant, la tension au point de test a diminue et le transistor TP4ecl constituant le générateur de courant 120 voit son courant drain-source augmenter en conséquence. La tension de grille des transistors TN17i et TN16i constitutifs de la résistance ajustable en tension 121, étant constante et égale à VCC, et, en raison du fait que le courant du transistor TP4ecl augmente, la tension au point de test b, point commun 13, étant sensiblement fixe, la tension au point de test c, point de sortie du signal délivré par le circuit 1 générateur de signal en phase, augmente en conséquence, ce d'autant plus que la résistance entre le point commun 13, point de test b, et point de test c est élevée. Cette résistance, ajustable, permet ainsi d'obtenir un gain en tension et une modification du point de commutation par rapport au signal d'entrée ECL, le signal I.

La source de courant atténuée 14 permet l'écoulement des courants provenant des branches d'entrée et d'amplification 11 et 12 tout en limitant leurs valeurs et en empêchant leur déséquilibre.

En ce qui concerne une variation contraire du signal d'entrée ECL, c'est-à-dire lors d'une transition du signal I de 4,1 V à 3,2 V, il suffit de reprendre le processus précédent en considérant que l'ensemble des points communs ou noeuds évolue en sens contraire de celui décrit précédemment.

La source de courant atténuée 14 telle que représentée en figure 2a, opère de la façon ci-après. Les transistors TN15i et TN12i ont leur électrode de grille connectée au point de test i, c'est-à-dire à une source de tension dont la sortie n'est autre que l'électrode de grille du transistor TN25i. Cette grille étant connectée à l'électrode de grille des transistors TN61 et TN9i, eux-mêmes connectés par leur électrode de drain à la source de courant formée par les transistors TP8o et TP12o et en leur électrode de source à la résistance formée par les transistors TP3ecl et TN7ecl, il se développe au point de test k, le point de test j délivrant un courant constant aux bornes de la résistance composée par les transistors TP3ecl et TN7ecl, une tension constante car les électrodes de grille de ces deux derniers transistors sont connectées à la tension de référence VSS et à la tension d'alimentation au niveau CMOS VCC respectivement. La tension existant entre les noeuds i et k, tension grille-source des transistors précités, est constante car le courant circulant dans les transistors TN6i et TN9i est constant.

En conséquence, la tension au point de test i, c'est-à-dire au point commun 143, est constante, les transistors TP0o et TP1o servant à véhiculer un courant au travers du transistor TN25i, courant inverse au niveau des variations à celui circulant dans les transistors TP8o et TP12o.

En ce qui concerne le circuit inverseur à seuil 2, celui-ci est constitué par un circuit inverseur analogique à seuils positif et négatif identiques, la valeur de seuil étant centrée au niveau du point de commutation du signal de sortie du comparateur de courant. Le circuit inverseur 2, ainsi que représenté en figure 2a, est formé par les transistors TP7i, TPlecl et TN3ecl. La tension appliquée au point de test c, c'est-à-dire en sortie du circuit générateur d'un signal en phase, est ainsi inversée et amplifiée en tension au point de test e. On note que ces deux tensions se positionnent par rapport à un même point de commutation. Par conséquent, la différence entre ces deux tensions est soit positive, soit négative, suivant la tension d'entrée I appliquée au niveau ECL.

Pour ce qui concerne le circuit 3 de mise en forme, on indique que le comparateur de tension à sortie unique 30 permet de comparer la tension d'entrée au point de test c présente sur l'électrode de grille du transistor TP11o et la tension de sortie au point de test e délivrée par le circuit inverseur 2. Le comparateur de tension à sortie unique 30 est formé par les transistors TP11o, TP13o, TN10i et TN11i. Lorsque la tension au point de test c s'élève alors que la tension au point de test e s'abaisse en conséquence, vers sa valeur la plus basse, la tension en sortie du comparateur de tension à sortie unique 30, c'est-à-dire au point de test g, s'élève et vice-versa. Il est donc possible d'augmenter en outre le gain de tension de l'ensemble du dispositif selon l'invention.

Le circuit inverseur de mise en forme proprement dit 31 permet de transformer les variations de tension au point de test g en des variations de tension au niveau CMOS au point de test h. Le circuit 31 est formé par les transistors TP0ecl, TP2ecl et TN9ecl. Le circuit 31 est un simple inverseur CMOS dont le point de commutation est choisi égal à la valeur moyenne de l'amplitude de tension qui apparaît au point de test g, point de sortie du comparateur de tension à sortie unique 30.

Enfin le circuit amplificateur inverseur de sortie 4 est avantageusement formé par un inverseur de type CMOS permettant d'augmenter le courant en sortie lors de la commutation du circuit inverseur de mise en forme 3. Le circuit amplificateur de sortie est formé par les transistors TP3o, TP21o, TN5ecl et TN4ecl. L'entrée de l'amplificateur de sortie 4 est formée par le point de test h et la borne de sortie de celui-ci, délivrant le signal au niveau CMOS en phase avec le signal d'entrée, est notée O. Le circuit amplificateur de sortie permet de commuter rapidement la ligne de connexion reliant ce dernier à une matrice de connexion d'une mémoire CMOS par exemple, afin de commander une cellule de mémorisation de la mémoire précitée avec des temps de montée et de descente suffisamment courts. Ainsi, par voie de conséquence, le temps de propagation des signaux de commutation au coeur de la matrice est minime.

En ce qui concerne la commande de réduction de la consommation statique d'énergie électrique en mode veille, on indique que ce signal E permet non seulement de couper la consommation statique des quatre modules précités, et donc d'arrêter leur fonctionnement, mais également d'engendrer un niveau CMOS en sortie, O, afin d'inhiber la consommation statique d'énergie électrique de la cellule de la matrice de mémorisation précitée.

Lorsque la tension du signal de commande E est par exemple égale à 0 V, le dispositif selon l'invention fonctionne normalement, alors que pour E = VCC par exemple, le circuit 1 générateur d'un signal en phase avec le signal d'entrée ne fonctionne plus car la source de courant atténuée 14 est amenée en circuit ouvert, ainsi que représenté symboliquement en figure 1 et de manière physique en figure 2a, la mise en circuit ouvert étant effectuée grâce au transistor TN11o.

En outre, pour E = VCC, la tension au point de test d, c'est-à-dire sur l'électrode de grille du transistor TP5o, est à la tension de référence VSS, soit 0 V et le transistor précité est conducteur ce qui a pour effet de positionner le point de test c et donc l'entrée du circuit inverseur 2 à la tension d'alimentation VCC. En raison de l'inversion effectuée par le circuit inverseur 2, la tension au point de test e est alors égale à la tension de référence VSS.

En ce qui concerne le circuit de mise en forme 3, lorsque la tension de commande E est égale à VCC, le transistor TN14o est rendu conducteur, ce qui a pour effet de bloquer les étages constitutifs du comparateur de tension à sortie unique 30 ainsi que le positionnement de la sortie de celui-ci, c'est-à-dire le point de test g, à là valeur de la tension d'alimentation VCC. En conséquence et en raison de l'inversion effectuée par le circuit inverseur de mise en forme proprement dit 31, la sortie de ce dernier, soit le point de test h, est positionnée à la valeur de la tension de référence VSS, et la borne de sortie 0 du circuit amplificateur et du dispositif selon l'invention est alors positionnée à la valeur de tension d'alimentation VCC, ce qui correspond au niveau haut maximum en technologie CMOS.

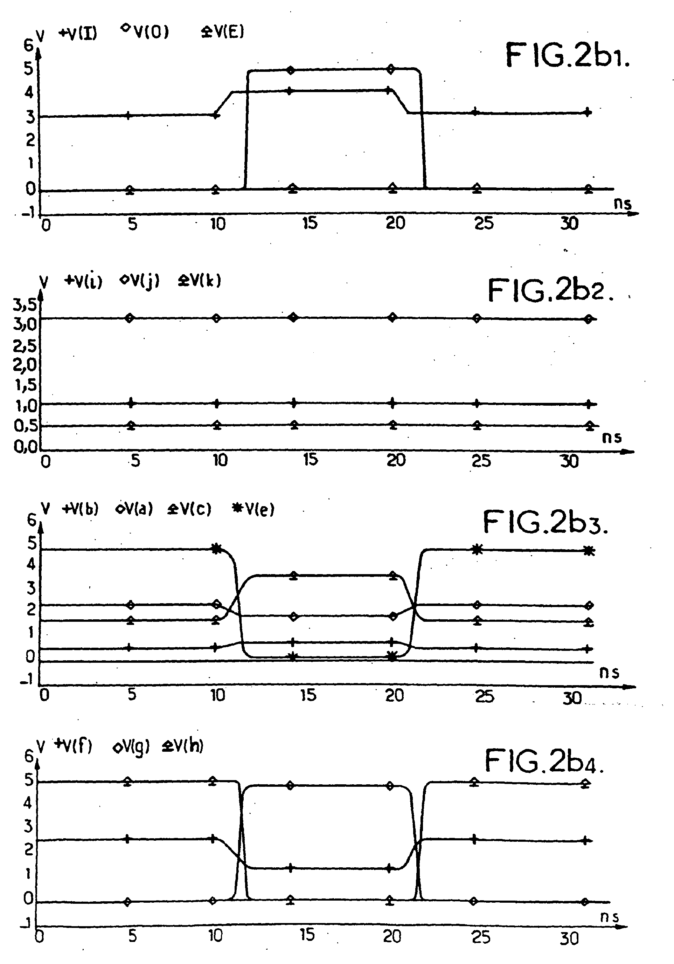

Les formes d'ondes obtenues aux points de test a à k de la figure 2a pour un signal d'entrée ECL, I, un signal de commande E et un signal de sortie O sont représentées en figures 2b1, 2b3 et 2b4, l'axe des abscisses étant gradué en ns et l'axe des ordonnées en volts.

On indique en outre que l'ensemble des modules précédemment décrits est alors peu sensible à des variations minimes de la largeur des transistors NMOS mis en oeuvre, ce qui présente un avantage lorsque le dispositif objet de la présente invention est spécialement dédié à des applications dans lesquelles les conditions de fonctionnement sont extrêmes. Dans un tel cas, il est nécessaire de positionner, dans les transistors précités, des zones d'inhibition du transistor au niveau des becs d'oiseau, c'est-à-dire des zones de grille de polysilicium passant de l'oxyde épais à l'oxyde mince des transistors NMOS afin d'éviter le contournement par l'extérieur du transistor NMOS du courant drain-source. L'introduction de ces zones d'inhibition du transistor, encore appelées vignettes, provoque une réduction des largeurs des transistors NMOS précités mais, en raison du fait que la structure globale est équipée de modules qui se suivent en ce qui concerne la variation des seuils de commutation, l'ensemble de la structure du dispositif selon l'invention reste fonctionnel. En outre, le dispositif objet de l'invention ainsi réalisé, toutes proportions gardées, conserve les mêmes propriétés électriques de temps de propagation, de temps de montée et de temps de descente lors des commutations.

On a ainsi décrit un dispositif d'interfaçage de signaux logiques du niveau ECL au niveau CMOS particulièrement performant dans la mesure où ce dispositif permet la communication entre ces deux environnements logiques dans des conditions extrêmes de variations de tension, de température, de fonctionnement, sans aucunement introduire une tension de référence, seules de faibles variations de comportement électrique des transistors de type CMOS utilisés étant introduites dans le cas où de tels dispositifs sont destinés à des applications dans des conditions de fonctionnement extrêmes.

Outre le caractère de simplicité de la structure du dispositif et de l'utilisation de ce dernier, on indique que le dispositif selon l'invention permet également un gain de surface en termes de connexions à réaliser, de facilité d'utilisation et de faible niveau de bruit en sortie en raison de la faible valeur d'intensité des courants de commutation mis en oeuvre.

Les avantages précités sont obtenus au prix de contraintes tout-à-fait acceptables telles qu'une dissipation thermique plus élevée que les dispositifs classiques, cette dissipation thermique étant toutefois constante, et d'implantation de transistors dont les caractéristiques topologiques sont plus sophistiquées que les transistors de type classique.

## Revendications

1. Dispositif d'interfaçage de signaux logiques du niveau ECL au niveau CMOS, **caractérisé en ce qu'**il comprend, alimentés par une tension d'alimentation au niveau CMOS, par rapport à une tension de référence, et connectés en cascade :
- un circuit (1) générateur d'un signal en phase avec un signal d'entrée au niveau ECL, ce signal en phase présentant une amplitude supérieure à celle du signal d'entrée et une valeur d'amplitude moyenne supérieure à celle du signal d'entrée au niveau ECL, ledit circuit (1) générateur d'un signal en phase avec le signal d'entrée comprenant :
* un circuit comparateur formé par une branche d'entrée et une branche d'amplification connectées en parallèle entre la tension d'alimentation au niveau CMOS et un point commun (13), la branche d'entrée et la branche d'amplification étant formées chacune par, un générateur de courant (110,120) et une résistance (111,121) ajustable en tension, la sortie (11) du générateur de courant (110) de la branche d'entrée étant couplée à une entrée de commande du générateur de courant (120) de la branche d'amplification, une entrée de commande de la résistance (111) ajustable en tension de la branche d'entrée étant reliée à une borne d'entrée recevant ledit signal d'entrée au niveau ECL et une entrée de commande de la résistance (121) ajustable de la branche d'amplification étant reliée à la tension d'alimentation au niveau CMOS, et
* une source de courant atténuée (14), connectée en cascade avec la branche d'entrée et la branche d'amplification en parallèle, entre le point commun (13) et la tension de référence (VSS), ce qui permet de délivrer ladite tension en phase au niveau du point de connexion entre le générateur de courant (120) et la résistance ajustable en tension (121) de la branche d'amplification,
- un circuit (2) inverseur à seuil, dont la valeur de seuil est sensiblement égale à la valeur d'amplitude moyenne du signal en phase, ce circuit inverseur (2) recevant sur une entrée d'inversion ledit signal en phase et délivrant un signal en phase inversé ;
- un circuit (3) de mise en forme recevant ledit signal en phase inversé et comprenant un comparateur (30) de tension à sortie unique recevant sur ses entrées de comparaison le signal en phase inversé et le signal en phase respectivement, et délivrant un signal de comparaison du signal en phase et du signal en phase inversé, constituant un signal en phase calibré et un module (31) inverseur de mise en forme proprement dit recevant ledit signal de comparaison du signal en phase et du signal en phase inversé délivrant un signal en phase calibré inversé ;
- un circuit (4) amplificateur inverseur de sortie recevant le signal en phase calibré inversé et délivrant un signal de sortie, au niveau CMOS, en phase avec le signal d'entrée au niveau ECL.

2. Dispositif selon la revendication 1, **caractérisé en ce que** ledit circuit (2) inverseur à seuil comprend :
- un premier (TP7i) et un deuxième (TP1ecl) transistor PMOS connectés en parallèle entre la tension d'alimentation CMOS et un point commun (e), les électrodes de grille du premier et deuxième transistor PMOS étant connectées en sortie dudit circuit (1) générateur d'un signal en phase et recevant ledit signal en phase ;
- un transistor NMOS (TN3ecl) connecté en cascade entre ledit point commun (e) et la tension de référence (VSS), l'électrode de grille dudit transistor NMOS étant connectée en sortie dudit circuit (1) générateur d'un signal en phase et recevant ledit signal en phase, ledit circuit (2) inverseur à seuil délivrant au point commun ledit signal en phase inversé.

3. Dispositif selon l'une des revendications 1 ou 2, **caractérisé en ce que** ledit circuit (4) amplificateur inverseur de sortie comprend :
- un premier (TP21₀) et un deuxième (TP3₀) transistor PMOS connectés en parallèle entre la tension d'alimentation (VCC) au niveau CMOS et un point commun (h) ;
- un premier (TN5ecl) et un deuxième (TN4ecl) transistor NMOS connectés en parallèle entre ledit point commun (O) et la tension de référence (VSS), les électrodes de grille des premiers et deuxièmes transistors PMOS respectivement NMOS étant reliées en sortie dudit circuit de mise en forme et recevant ledit signal en phase calibré, ledit point commun (O), délivrant ledit signal de sortie au niveau CMOS.

4. Dispositif selon l'une des revendications précédentes, **caractérisé en ce que** le circuit (1) générateur d'un signal en phase, le circuit (2) inverseur à seuil et le circuit (3) de mise en forme comportent un circuit de commande recevant un signal de commande (E) permettant de réduire la consommation statique d'énergie électrique en mode veille et d'appliquer en sortie du circuit (4) amplificateur un signal de sortie au niveau CMOS permettant d'inhiber la consommation statique d'un circuit aval connecté à cette sortie.

5. Dispositif selon l'une des revendications 1 à 4 précédentes, **caractérisé en ce que** ladite source de courant atténuée (14) comprend :
- un premier (TN15i) et un deuxième (TN12i) transistor NMOS connectés en parallèle entre ledit point commun (13) et la tension de référence (VSS) ;
- un module de commande d'atténuation délivrant une tension de commande d' atténuation à l'électrode de grille dudit premier (TN15i) et deuxième (TN12i) transistor NMOS.

6. Dispositif selon la revendication 5, **caractérisé en ce que** ledit module de commande d'atténuation comprend :
- une source de courant formée par un premier (TP8₀) et un deuxième (TP12₀) transistor PMOS connectés en parallèle entre la tension d'alimentation (VCC) au niveau CMOS et un premier point commun (141), l'électrode de grille du premier et du deuxième transistor PMOS étant connectée audit premier point commun, lequel délivre un courant constant ;
- une résistance formée par un transistor PMOS (TP3ecl) et un transistor NMOS (TN7ecl) connectés en parallèle entre un deuxième point commun (142) et la tension de référence (VSS) et dont l'électrode de grille est reliée à la tension de référence (VSS) respectivement à la tension d'alimentation (VCC) au niveau CMOS ;
- un circuit générateur de tension formé par un premier (TN6i) et un deuxième (TN9i) transistor NMOS connectés en parallèle entre le premier (141) et le deuxième (142) point commun, l'électrode de grille du premier et du deuxième transistor NMOS étant reliée à un troisième point commun (143) auquel est interconnectée l'électrode de grille du premier (TN15i) et du deuxième (TN12i) transistor NMOS formant ladite source de courant atténuée, le circuit générateur de tension comprenant en outre, d'une part, un premier (TPO₀) et un deuxième (TP1₀) transistor PMOS connectés en parallèle entre la tension d'alimentation (VCC) au niveau CMOS et un quatrième point commun (i) , l'électrode de grille desdits premier (TPO₀) et deuxième (TPl₀) transistor PMOS étant connectée à l'électrode de grille du premier (TP8₀) et du deuxième (TP12₀) transistor PMOS constituant la source de courant, et, d'autre part, un transistor NMOS (TN25i) connecté entre ledit quatrième point commun (i) et la tension de référence (VSS), l'électrode de grille de ce transistor NMOS (TN25i) étant reliée audit troisième point commun (143) et délivrant la tension de commande d'atténuation.

## Claims

1. ECL level / CMOS level logic signal interfacing device, **characterised in that** it comprises the following, supplied by a supply voltage at CMOS level, in relation to a reference voltage, and connected in cascade:
- a generator circuit (1) for a signal in phase with an input signal at ECL level, this in-phase signal having an amplitude which is greater than that of the input signal and an average amplitude value which is greater than that of the input signal at ECL level, said generator circuit for a signal in phase with the input signal comprising:
* a comparator circuit formed by an input branch and an amplification branch connected in parallel between the supply voltage at CMOS level and a common point (13), the input branch and the amplification branch each being formed by a power generator (110, 120) and a resistor (111, 121) with adjustable voltage, the output (11) of the power generator (110) of the input branch being coupled to a command input of the power generator (120) of the amplification branch, a command input of the resistor (111) with adjustable voltage of the input branch being connected to an input terminal receiving said input signal at ECL level and a command input of the adjustable resistor (121) of the amplification branch being connected to the supply voltage at CMOS level, and
* an attenuated power source (14) connected in cascade with the input branch and the amplification branch in parallel between the common point (13) and the reference voltage (VSS), allowing said voltage to be supplied in phase at the connection point between the power generator (120) and the resistor with adjustable voltage (121) of the amplification branch,
- a threshold inverter circuit (2), of which the threshold value is approximately equal to the average amplitude value of the in-phase signal, this inverter circuit (2) receiving said in-phase signal at an inversion input and supplying an inverted in-phase signal;
- a conditioning circuit (3) receiving said inverted in-phase signal and comprising a single output voltage comparator (3) receiving at its comparison inputs the inverted in-phase signal and the in-phase signal respectively and supplying a comparison signal of the in-phase signal and the inverted in-phase signal, constituting a calibrated in-phase signal and a conditioning inverter module (31) in the strict sense of the term receiving said comparison signal of the in-phase signal and the inverted in-phase signal, supplying an inverted, calibrated in-phase signal;
- an output inverter amplifier circuit (4) receiving the inverted, calibrated in-phase signal and supplying an output signal at CMOS level in phase with the input signal.

2. Device according to claim 1, **characterised in that** said threshold inverter circuit (2) comprises:
- a first (TP7i) and a second (TP1ecl) PMOS transistor connected in parallel between the CMOS supply voltage and a common point (e), the grid electrodes of the first and second PMOS transistor being connected at the output of said in-phase signal generator circuit (1) and receiving said in-phase signal;
- a NMOS transistor (TN3ecl) connected in cascade between said common point (e) and the reference voltage (VSS), the grid electrode of said NMOS transistor being connected at the output of said in-phase signal generator circuit (1) and receiving said in-phase signal, said threshold inverter circuit (2) supplying at the common point said inverted in-phase signal.

3. Device according to one of the claims 1 or 2, **characterised in that** said output inverter amplifier circuit (4) comprises:
- a first (TP21₀) and a second (TP3₀) PMOS transistor connected in parallel between the supply voltage (VCC) at CMOS level and a common point (h);
- a first (TN5ecl) and a second (TN4ecl) NMOS transistor connected in parallel between said common point 0 and the reference voltage (VSS), the grid electrodes of the first and second PMOS / NMOS transistors being connected at the output of said conditioning circuit and receiving said calibrated in-phase signal, said common point 0 supplying said output signal at CMOS level.

4. Device according to one of the preceding claims, **characterised in that** the in-phase signal generator circuit (1), the threshold inverter circuit (2) and the conditioning circuit (3) comprise a command circuit receiving a command signal (E) allowing static electrical energy consumption to be reduced in standby mode and application at the output of the amplifier circuit (4) of an output signal at CMOS level allowing the static consumption of a downstream circuit connected to this output to be inhibited.

5. Device according to one of the preceding claims 1 to 4, **characterised in that** said attenuated power source (14) comprises:
- a first (TN15i) and a second (TN12i) NMOS transistor connected in parallel between said common point (13) and the reference voltage (VSS);
- an attenuation command module supplying an attenuation command voltage to the grid electrode of said first (TN15i) and second (TN12i) NMOS transistor.

6. Device according to claim 5, **characterised in that** said attenuation command module comprises:
- a power source formed by a first (TP8₀) and a second (TP12₀) PMOS transistor connected in parallel between the supply voltage (VCC) at CMOS level and a first common point (141), the grid electrode of the first and second PMOS transistor being connected to said first common point which supplies a constant current;
- a resistor formed by a PMOS transistor (TP3ecl) and a NMOS transistor (TN7ecl) connected in parallel between a second common point (142) and the reference voltage (VSS) and of which the grid electrode is connected to the reference voltage (VSS) / to the supply voltage (VCC) at CMOS level;
- a voltage generator circuit formed by a first (TN6i) and a second (TN9i) NMOS transistor connected in parallel between the first (141) and the second common point (142), the grid electrode of the first and the second NMOS transistor being connected to a third common point (143) to which is interconnected the grid electrode of the first (TN15i) and of the second (TN12i) NMOS transistor forming said attenuated power source, the voltage generator circuit also comprising on the one hand a first (TPO₀) and a second (TP1₀) PMOS transistor connected in parallel between the supply voltage (VCC) at CMOS level and a fourth common point (i), the grid electrode of said first (TPO₀) and second (TP1₀) PMOS transistor being connected to the grid electrode of the first (TP8₀) and the second (TP12₀) PMOS transistor constituting the power source and on the other hand a NMOS transistor (TN25i) connected between said fourth common point (i) and the reference voltage (VSS), the grid electrode of this NMOS transistor (TN25i) being connected to said third common point (143) and supplying the attenuation command voltage.

## Patentansprüche

1. Vorrichtung zur Bildung einer Schnittstelle für logische Signale vom Niveau ECL zum Niveau CMOS, **dadurch gekennzeichnet, dass** sie, von einer Versorgungsspannung auf dem Niveau CMOS versorgt, in Bezug auf eine Referenzspannung und in Kaskade angeschlossen, umfasst:
- eine Schaltung (1) zur Erzeugung eines phasengleichen Signals mit einem Eingangssignal auf dem Niveau ECL, wobei dieses phasengleiche Signal eine größere Amplitude als jenes des Eingangssignals und einen durchschnittlichen Amplitudenwert größer als jener des Eingangssignals auf dem Niveau ECL aufweist, wobei die Schaltung (1) zur Erzeugung eines phasengleichen Signals mit dem Eingangssignal umfasst:
• eine Vergleichsschaltung, die von einem Eingangsabschnitt und einem Verstärkungsabschnitt gebildet ist, die parallel zwischen der Versorgungsspannung auf dem Niveau CMOS und einem gemeinsamen Punkt (13) angeschlossen sind, wobei der Eingangsabschnitt und der Verstärkungsabschnitt jeweils von einem Stromgenerator (110, 120) und einen hinsichtlich der Spannung einstellbaren Widerstand (111, 112) gebildet sind, wobei der Ausgang (11) des Stromgenerators (110) des Eingangsabschnitts mit einem Steuereingang des Stromgenerators (120) des Verstärkungsabschnitts gekoppelt ist, und ein Steuereingang des hinsichtlich der Spannung einstellbaren Widerstandes (111) des Eingangsabschnitts mit einer Eingangsklemme, die das Eingangssignal auf dem Niveau ECL empfängt, verbunden ist und ein Steuereingang des einstellbaren Widerstandes (121) des Verstärkungsabschnitts mit der Versorgungsspannung auf dem Niveau CMOS verbunden ist, und
• eine Dämpfungsstromquelle (14), die in Kaskade an den Eingangsabschnitt und den Verstärkungsabschnitt parallel zwischen dem gemeinsamen Punkt (13) und der Referenzspannung (VSS) angeschlossen ist, wodurch es möglich ist, die phasengleiche Spannung auf dem Niveau des Anschlusspunktes zwischen dem Stromgenerator (120) und dem hinsichtlich der Spannung einstellbaren Widerstand (121) des Verstärkungsabschnitts zu liefern,
- eine Schellenumkehrschaltung (2), deren Schwellenwert im Wesentlichen gleich dem durchschnittlichen Amplitudenwert des phasengleichen Signals ist, wobei diese Umkehrschaltung (2) an einem Umkehreingang das phasengleiche Signal empfängt und ein Signal mit umgekehrter Phase liefert;
- eine Formgebungsschaltung (3), die das Signal mit umgekehrter Phase empfängt und einen Spannungskomparator (30) mit einem einzigen Ausgang umfasst, der an seinen Vergleichseingängen das Signal mit umgekehrter Phase bzw. das phasengleiche Signal empfängt und ein Vergleichssignal des phasengleichen Signals und des Signals mit umgekehrter Phase liefert, das ein Signal mit kalibrierter Phase darstellt, und wobei ein eigentliches Umkehrformgebungsmodul (31) das Vergleichssignal des phasengleichen Signals und des Signals mit umgekehrter Phase, das ein Signal mit umgekehrter kalibrierter Phase liefert, empfängt;
- eine Umkehrausgangsverstärkungsschaltung (4), die das Signal mit umgekehrter kalibrierter Phase empfängt und ein Ausgangssignal auf dem Niveau CMOS liefert, das phasengleich mit dem Eingangssignal auf dem Niveau ECL ist.

2. Vorrichtung nach Anspruch 1, **dadurch gekennzeichnet, dass** die Schwellenumkehrschaltung (2) umfasst:
- einen ersten (TP7i) und einen zweiten (TPlecl) Transistor PMOS, die parallel zwischen der Versorgungsspannung CMOS und einem gemeinsamen Punkt (e) angeschlossen sind, wobei die Gate-Elektroden des ersten und des zweiten Transistors PMOS am Ausgang der Schaltung (1) zur Erzeugung eines phasengleichen Signals angeschlossen sind und das phasengleiche Signal empfangen;
- einen Transistor NMOS (TN3ecl), der in Kaskade zwischen dem gemeinsamen Punkt (e) und der Referenzspannung (VSS) angeschlossen ist, wobei die Gate-Elektrode des Transistors NMOS am Ausgang der Schaltung (1) zur Erzeugung eines phasengleichen Signals angeschlossen ist und das phasengleiche Signal empfängt, wobei die Schwellenumkehrschaltung (2) an den gemeinsamen Punkt das Signal mit umgekehrter Phase liefert.

3. Vorrichtung nach einem der Ansprüche 1 oder 2, **dadurch gekennzeichnet, dass** die Umkehrverstärkungsausgangsschaltung (4) umfasst:
- einen ersten (TP21₀) und einen zweiten (TP3₀) Transistor PMOS, die parallel zwischen dem gemeinsamen Punkt (O) und der Referenzspannung (VSS) angeschlossen sind, wobei die Gate-Elektroden der ersten bzw. zweiten Transistoren NMOS am Ausgang der Formgebungsschaltung angeschlossen sind und das Signal mit kalibrierter Phase empfangen, wobei der gemeinsame Punkt (O) das Ausgangssignal auf dem Niveau CMOS liefert.

4. Vorrichtung nach einem der vorhergehenden Ansprüche, **dadurch gekennzeichnet, dass** die Schaltung (1) zur Erzeugung eines phasengleichen Signals, die Schwellenumkehrschaltung (2) und die Formgebungsschaltung (3) eine Steuerschaltung umfassen, die ein Steuersignal (E) empfängt, das es ermöglicht, den statischen Stromverbrauch im Wachmodus zu verringern und am Ausgang der Verstärkerschaltung (4) ein Ausgangssignal auf dem Niveau CMOS anzulegen, das es ermöglicht, den statischen Verbrauch einer an diesen Ausgang angeschlossenen stromabwärtigen Schaltung zu hemmen.

5. Vorrichtung nach einem der vorhergehenden Ansprüche 1 bis 4, **dadurch gekennzeichnet, dass** die Dämpfungsstromquelle (14) umfasst:
- einen ersten (TN15i) und einen zweiten (TN12i) Transistor NMOS, die parallel zwischen dem gemeinsamen Punkt (13) und der Referenzspannung (VSS) angeschlossen sind;
- ein Dämpfungssteuermodul, das eine Dämpfungssteuerspannung an die Gate-Elektrode des ersten (TN15i) und des zweiten (TN12i) Transistors NMOS liefert.

6. Vorrichtung nach Anspruch 5, **dadurch gekennzeichnet, dass** das Dämpfungssteuermodul umfasst:
- eine Stromquelle, die von einem ersten (TP8₀) und einem zweiten (TP12₀) Transistor PMOS gebildet ist, die parallel zwischen der Versorgungsspannung (VCC) auf dem Niveau CMOS und einem ersten gemeinsamen Punkt (141) angeschlossen sind, wobei die Gate-Elektrode des ersten und des zweiten Transistors PMOS an den ersten gemeinsamen Punkt angeschlossen ist, der einen konstanten Strom liefert;
- einen Widerstand, der von einem Transistor PMOS (TP3ecl) und einem Transistor NMOS (TN7ecl) gebildet ist, die parallel zwischen einem zweiten gemeinsamen Punkt (142) und der Referenzspannung (VSS) angeschlossen sind, wobei die Gate-Elektrode an die Referenzspannung (VSS) bzw. die Versorgungsspannung (VCC) auf dem Niveau CMOS angeschlossen ist;
- eine Schaltung zur Spannungserzeugung, die von einem ersten (TN6i) und einem zweiten (TN9i) Transistor NMOS gebildet ist, die parallel zwischen dem ersten (141) und dem zweiten (142) gemeinsamen Punkt angeschlossen sind, wobei die Gate-Elektrode des ersten (TN15i) und des zweiten (TN12i) Transistors NMOS an einen dritten gemeinsamen Punkt (143) angeschlossen ist, mit dem die Gate-Elektrode des ersten (TN15i) und des zweiten (TN12i) Transistors NMOS, der die Dämpfungsstromquelle bildet, verbunden ist, wobei die Schaltung zur Spannungserzeugung ferner einerseits einen ersten (TP0₀) und einen zweiten (TP1₀) Transistor PMOS umfasst, die parallel zwischen der Versorgungsspannung (VCC)auf dem Niveau CMOS und einem vierten gemeinsamen Punkt (i) angeschlossen sind, wobei die Gate-Elektrode des ersten (TP0₀) und des zweiten (TP1₀) Transistors PMOS an die Gate-Elektrode des ersten (TP8₀) und des zweiten (TP12₀) Transistors PMOS, der die Stromquelle darstellt, angeschlossen ist, und andererseits einen Transistor (TN25i) umfasst, der zwischen dem vierten gemeinsamen Punkt (i) und der Referenzspannung (VSS) angeschlossen ist, wobei die Gate-Elektrode dieses Transistors (TN25i) an den dritten gemeinsamen Punkt (143) angeschlossen ist und die Dämpfungssteuerspannung liefert.
